(19) Europäisches Patentamt European Patent Office Office européen des brevets

(11) **EP 3 460 936 B1**

(12) **EUROPEAN PATENT SPECIFICATION**

(45) Date of publication and mention of the grant of the patent:
**26.07.2023 Bulletin 2023/30**

(21) Application number: **17891483.4**

(22) Date of filing: **11.05.2017**

(51) International Patent Classification (IPC):
**H02H 7/26** *(2006.01)*      **H02H 3/30** *(2006.01)*
**G01R 31/08** *(2020.01)*

(52) Cooperative Patent Classification (CPC):
**H02H 3/30;** G01R 31/086; Y04S 10/52

(86) International application number:
**PCT/CN2017/083926**

(87) International publication number:
**WO 2018/129842 (19.07.2018 Gazette 2018/29)**

(54) **PILOT PROTECTION METHOD FOR TRANSMISSION LINE OF NEW ENERGY STATION BASED ON CURRENT WAVEFORM SIMILARITY**

PILOTSCHUTZVERFAHREN FÜR ÜBERTRAGUNGSLEITUNG EINER NEUEN ENERGIESTATION AUF DER BASIS VON WELLENFORMÄHNLICHKEIT

PROCÉDÉ DE PROTECTION DE PILOTE POUR LIGNE DE TRANSMISSION D'UNE NOUVELLE STATION D'ÉNERGIE SUR LA BASE D'UNE SIMILARITÉ DE FORME D'ONDE DE COURANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.01.2017 CN 201710017380**

(43) Date of publication of application:
**27.03.2019 Bulletin 2019/13**

(73) Proprietor: **North China Electric Power University Beijing 102206 (CN)**

(72) Inventors:
• **BI, Tianshu**
  **Beijing 102206 (CN)**
• **LI, Yanbin**
  **Beijing 102206 (CN)**
• **JIA, Ke**
  **Beijing 102206 (CN)**
• **YANG, Qixun**
  **Beijing 102206 (CN)**

(74) Representative: **Novagraaf Technologies Bâtiment O2 2, rue Sarah Bernhardt CS90017 92665 Asnières-sur-Seine Cedex (FR)**

(56) References cited:
CN-A- 102 255 291      CN-A- 102 590 693
CN-A- 102 590 704      CN-A- 105 356 428
CN-A- 105 356 428      CN-A- 105 891 676
CN-A- 105 891 676      CN-B- 102 288 874
US-A1- 2003 060 991

• DUAN, JIANDONG et al.: "Line Protection Based on Current Frequency Difference for Active Distribution Network", Proceedings of the Csee, vol. 36, no. 11, 5 June 2016 (2016-06-05), pages 2927-2934, XP009515470, ISSN: 0258-8013
• KONG, FEI et al.: "A Novel Pilot Protection Scheme for HVDC Transmission Lines Based on Waveform Correlation Analysis of Traveling Wave", Dian li xi tong zi dong hua = Automation of electric power systems, vol. 38, no. 20, 25 October 2014 (2014-10-25), pages 108-109, XP009515456, ISSN: 1000-1026, DOI: 10.7500/AEPS20130922015

## Description

This Application requires for Chinese patent application priority over the title of "Pilot Protection Method for Transmission Line of Renewable Energy Power Station Based on Current Waveform Similarity", which was submitted to CNIPA on January 10, 2017 with the application No. of 201710017380.3.

## Technical field

This Invention involves the relay protection field in renewable energy power system, especially concerning a pilot protection method for transmission line of renewable energy power station based on current waveform similarity.

## Background of the invention

In China, one of the main utilization methods for renewable energy resources such as wind power and photovoltaic energy is access to grid in the large-scale and cluster manner. Large-scale renewable energy power stations have a large generating capacity, and they often have access to grid via special high-voltage transmission line. When there is a fault in the grid, the renewable energy power supply shall not take off grid in order to improve the efficiency of renewable energy utilization and guarantee the safe and stable system operation. As a result, the relay protection for grid is required to reliably and rapidly remove failures. With the transmission line as the key channel for large-scale renewable energy power station power delivery, it is crucial for the equipped relay protection to take correct actions in case of grid failure.

Currently, the transmission lines have widely adopted the relay protections such as differential protection and distance protection based on traditional power frequency component. However, the wind generation set, photovoltaic cell and other renewable energy power supplies are different from synchronous generators in terms of electric-generation principle, control mode and grid-connection methods. The characteristic of short-circuit current provided by the renewable energy power station are entirely different from those of traditional synchronous generators, and both sensitivity and good speed decline when differential protection, distance protection and other traditional relay protections are applied to transmission line. Moreover, as the scale of renewable energy power supply connecting to the grid increases constantly, the risk of maloperation exists in traditional protections. Therefore, it is required to research a more outstanding new principle protection for transmission line.

Patent document CN105356428 discloses a method based on the time-domain model identification. Differential voltage and current of two line terminals conform to capacitance model at external fault state, but do not conform at internal fault state. Pearson algorithm is used to determine whether the differential voltage and current conform the capacitance model. The data for similarity comparison are the differential current and the derivative of differential voltage.

Patent document CN105891676 discloses a method based on boundary elements (capacitor branch of DC lines) of the transmission line. There is a difference on the polarity between the current of the capacitor branch and the current of the DC line in case of internal and external faults. The polarity difference can be calculated by Pearson algorithm. The data for similarity comparison are the current of capacitor branch on both sides and the current of the DC line, respectively.

## Summary of the Invention

According to the invention there is provided a pilot protection method as defined in claim 1. Further developments of the invention are the subject of the dependent claims.

This Invention is designed to provide a pilot protection method for transmission line of renewable energy power station based on current waveform similarity, which is of high reliability and sensitivity as well as good speed, applicable to various types of renewable energy power stations.

The purpose of this Invention is realized by following technical schemes:

A pilot protection method for transmission line of renewable energy power station based on current waveform similarity, comprising:

Mount identical relay protection devices respectively on sides M and N of a transmission line of the renewable energy power station, with each protection device independently measuring the three-phase current of its own side, and acquiring the three-phase current of the opposite side by means of a communication channel;

Each set of relay protection device calculates correlation coefficients according to the same-phase current sampled values within the same time window at the same time on the own side and the opposite side;

And each set of relay protection device judges whether there is a fault inside the internal transmission line of the renewable energy power station based on the comparison between the set value and the calculated correlation coefficient of current of each phase and then enables protective measures according to the fault type.

It can be seen from the technical scheme provided by this Invention that whether a fault occurs in the internal transmission line can be judged based on the size relationship between the set value and the calculated correlation coefficients of the same phase short-circuit current waveforms on both sides of the transmission line. The method makes full use of the features of irregular changes of the short-circuit current waveform in the transient process of renewable energy power supply, and the built new principle protection of high reliability and sensitivity as well as a good speed is applicable to various types of renewable energy power stations with different capacities.

## Brief description of the Drawing

Figure 1 is the flow diagram for the pilot protection method for transmission line of renewable energy power station based on current waveform similarity provided by the Embodiment;
Figure 2 is the schematic diagram for the connection of relay protection devices of transmission line of renewable energy power station provided by the Embodiment;
Figure 3(a) and Figure 3(b) are logical control diagrams of relay protection devices in case of internal failures provided by the Embodiment;
Figure 4 is the schematic diagram of simulation model system provided by the Embodiment.

## Detailed Description of the Invention

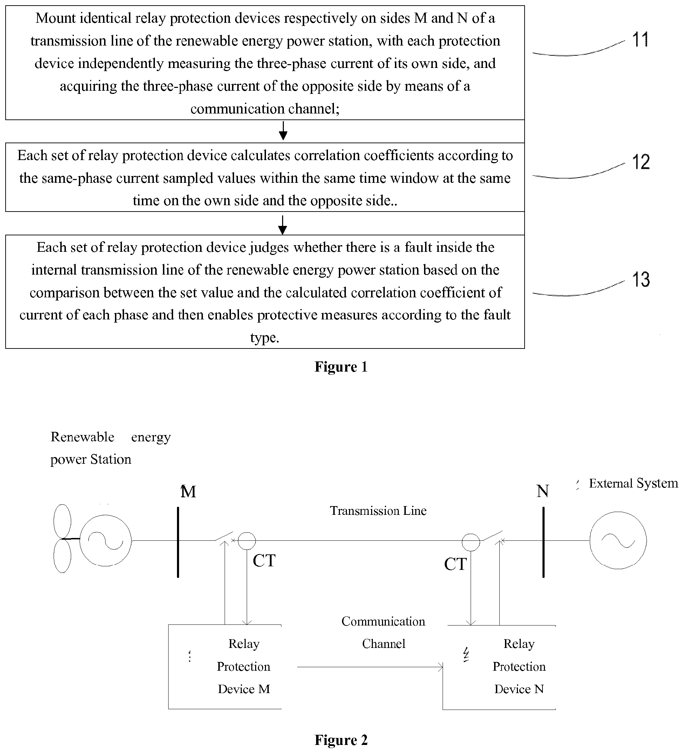

Figure 1 is the flow diagram for the pilot protection method for transmission line of renewable energy power station based on current waveform similarity provided by the Embodiment. As shown in Figure 1, it mainly includes the steps as below:
Step 11. Mount identical relay protection devices respectively on sides M and N of a transmission line of the renewable energy power station, with each protection device independently measuring the three-phase current of its own side, and acquiring the three-phase current of the opposite side by means of a communication channel.
As shown in Figure 2, the relay protection devices M and N are respectively mounted on M and N sides, with the data connectivity via communication channel.
Step 12, Each set of relay protection device calculates correlation coefficients according to the same-phase current sampled values within the same time window at the same time on the own side and the opposite side.
Considering that the transient response time of the converter control loop is generally not less than 8ms and in order to make use of the short-circuit current waveform characteristics in transient process as far as possible, ensure the protection sensitivity and protection speediness, the time window can be 10ms.
In the Embodiment, the similarity of two current waveforms after fault is used to build protection principle, and the correlation coefficient is used to measure the similarity of such two waveforms. The correlation coefficient is determined by the following formula:

$$r_p = \frac{\sum_{k=1}^{n}\left(i_{Mp}(k) - \frac{1}{n}\sum_{j=1}^{n}i_{Mp}(j)\right)\left(i_{Np}(k) - \frac{1}{n}\sum_{j=1}^{n}i_{Np}(j)\right)}{\sqrt{\sum_{i=1}^{n}\left(i_{Mp}(k) - \frac{1}{n}\sum_{j=1}^{n}i_{Mp}(j)\right)^2}\sqrt{\sum_{i=1}^{n}\left(i_{Np}(k) - \frac{1}{n}\sum_{j=1}^{n}i_{Np}(j)\right)^2}}, \quad p = A, B, C$$

In which, $r_p$ refers to the correlation coefficient of $p$-phase current on M and N sides; $n$ is the sampling number within Nms of the time window and satisfies $n = N \times 0.001 \times f_s$, $f_s$ is the sampling frequency of relay protection device; $i_{Mp}(k)$ and $i_{Mp}(j)$ are respectively the kth and jth $p$-phase current sampled values of the M side, $i_{Np}(k)$ and $i_{Np}(j)$ respectively the kth and jth p-phase current sampled values of the N side.
Step 13, Each set of relay protection device judges whether there is a fault inside the internal transmission line of the renewable energy power station based on the comparison between the set value and the calculated correlation coefficient of current of each phase and then enables protective measures according to the fault type.
It is mainly divided into the following situations:

If the correlation coefficient of current of A-phase, B-phase and C-phase are all less than the set value, it is judged that there is no fault in the internal transmission line of the renewable energy power station and the relay protection device requires no treatment;

If the correlation coefficient of current of any one of A-phase, B-phase and C-phase currents is more than the set value, it is judged that there is single-phase fault in the internal transmission line of the renewable energy power station and the fault phase is the one whose correlation coefficient is more than the set value. The relay protection device sends instructions to trip off the circuit breaker of the fault phase;

If the correlation coefficient of current of any two or three of A-phase, B-phase and C-phase currents is more than the set value, it is judged that there is two-phase or three-phase fault in the internal transmission line of the renewable energy power station, and the fault phases are those whose correlation coefficient is more than the set value. The relay protection device sends instructions to trip off the three-phase circuit breaker;

For the purpose of easy comprehension, the following description takes the calculation of A-phase current correlation coefficient of the relay protection device M on the M side as an example. Now the M side of transmission line is its own side, and N side is the opposite side. The relay protection device M samples A-phase current $i_{MA}$ of its own side by current transformer CT and acquires the same-time A-phase current $i_{NA}$ of the opposite side through communication channel. Considering that the transient response time for the converter control loop is generally not less than 8ms and in order to make use of the short-circuit current waveform characteristics in transient process as far as possible, ensuring the protection sensitivity and protection speediness, the time window can be 10ms. The set value is denoted as $r_{set}$. Considering the effect of the capacitive current of transmission line and CT transmission error, $r_{set}$ is -0.9.

Then calculate the correlation coefficient base on sampled A-phase current value within the same time window:

$$r_A = \frac{\sum_{k=1}^{n}\left(i_{MA}(k) - \frac{1}{n}\sum_{j=1}^{n}i_{MA}(j)\right)\left(i_{NA}(k) - \frac{1}{n}\sum_{j=1}^{n}i_{NA}(j)\right)}{\sqrt{\sum_{i=1}^{n}\left(i_{MA}(k) - \frac{1}{n}\sum_{j=1}^{n}i_{MA}(j)\right)^2}\sqrt{\sum_{i=1}^{n}\left(i_{NA}(k) - \frac{1}{n}\sum_{j=1}^{n}i_{NA}(j)\right)^2}}$$

Wherein: $r_A$ is the correlation coefficient of A-phase current on both sides; n is the sampling number within 10ms of the time window and satisfies $n=10\times0.001\times f_s$, $f_s$ is the sampling frequency of protection device M in the unit of Hz; $i_{MA}(k)$ and $i_{MA}(j)$ are respectively the kth and jth A-phase current sampled values on the M side of transmission line; $i_{NA}(k)$ and $i_{NA}(j)$ are respectively the kth and jth A-phase current sampled values on the Nside of transmission line.

When short-circuit fault occurs in external transmission line (areas outside the CTs on both sides), it is defined that the current's flow direction from busbar to line is the positive direction. It is known based on the Kirchhoffs Current Law that the A-phase current waveform of its own side is nearly contrary to that of the opposite side, with the effect of line capacitive current and CT transmission error, the correlation coefficient here is less than -0.9, i.e. $r_A < r_{set}$, so the M-side protection device has no action.

When short-circuit fault occurs in internal transmission line (areas within the CTs on both sides), the A-phase currents of its own side and the opposite side are respectively provided by renewable energy power station and external equivalent system. Affected by the controller's transient process, the A-phase current provided by renewable energy power station has irregular waveforms, while the waveform of A-phase current provided by external equivalent system mainly changes in the law of fundamental frequency sine wave, then the correlation coefficient here is more than -0.9, i.e. $r_A > r_{set}$, so M-side protection device has reliable actions.

The above describes the calculation of correlation coefficient of A-phase current of relay protection device M, internal and external fault judgment process and protection device actions. The treatment and judgment of B-phase and C-phase current waveform of the same device M are similar to that, so are the same treatment and judgment for three-phase current of its own side for protection device N.

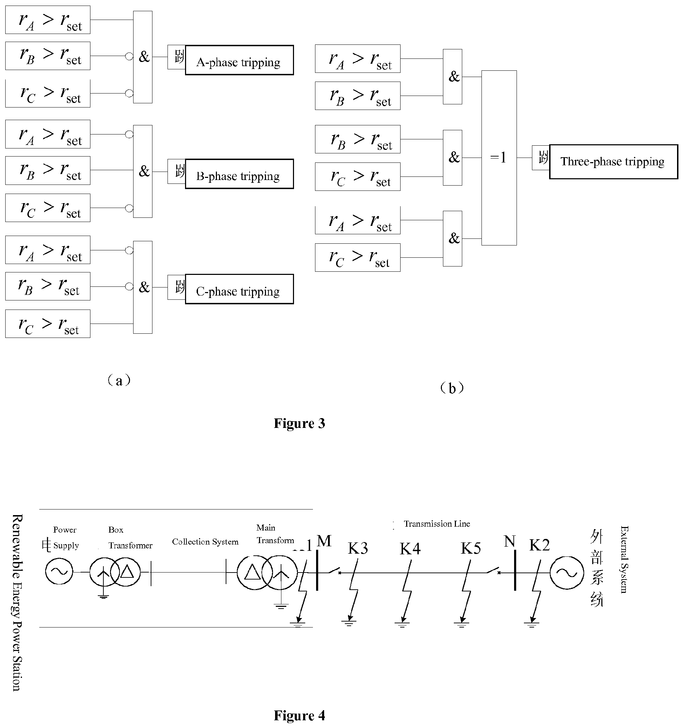

Figure 3 is the logical control diagram of relay protection device in case of internal fault, applicable to two sets of protection devices at the same time. In Figure 3, "&"is logic"and", and "≥1" is logic "or".

Still take the protection device M as an example. As shown in Figure 3(a), if there is output with "$r_k > r_{set}$", while no output with "$r_B > r_{set}$" and "$r_C > r_{set}$", then the transmission line has A-phase internal fault and relay protection device M sends instructions to trip off A-phase circuit breaker on its own side. If there is output with "$r_B > r_{set}$" , while no output with "$r_A > r_{set}$" and "$r_C > r_{set}$", then the internal transmission line has B-phase fault, and relay protection device M sends instructions to trip off B-phase circuit breaker on its own side. If there is output with "$r_C > r_{set}$" while no output with "$r_A > r_{set}$" and "$r_B > r_{set}$", then the internal transmission line has C-phase fault, and relay protection device M sends instructions to trip off C-phase trip circuit breaker on its own side.

As shown in Figure 3(b), if there is output with "$r_A > r_{set}$" and "$r_B > r_{set}$" or with "$r_A > r_{set}$" and "$r_C > r_{set}$", or with "$r_B > r_{set}$" and "$r_C > r_{set}$", or with all the three conditions, then the internal transmission line has two-phase or three-phase fault, and the relay protection device M sends instructions trip off the three-phase circuit breaker on its own side.

The protection device N on N side simultaneously conducts the same treatment and judgment as the protection device M, that is, the actions of both protection devices are identical.

The closed loop test results of the Invention on electric system real-time simulation system (RTDS) is below. The simulation system's primary connection is shown in Figure 4, with the voltage class of 220kV, the sampling frequency of 1,000Hz and the rated capacity of renewable energy power station of 495MW. The renewable energy power supply is of inversion type with the rated capacity of 1.5MW and rated voltage of 0.69kV. The box transformer has a rated capacity of 3.5MVA, rated voltage of 35kV/0.69kV, in Dyn connection, with the short-circuit impedance of 6.76%. Equivalent collection line has a resistance of 0.1 IQ and the inductance of 409.5uH. The main transformer has a rated capacity of 500MVA, rated voltage of 220kV/35kV, in YNd connection, with the short-circuit impedance of 6%. The transmission line has a total length of 40km, with both positive and negative sequence impedances being 0.076+j0.338Ω/km and the zero-sequence impedance of 0.284+j0.824Ω/km. The impedances of three sequences in external system are all 0.2+j6.283Q.

There is a total of 5 fault positions, with two at the external outlets on the M-side and N-side of transmission line and the other three inside in distances of 10km/20km/30km to the station side, respectively denoted as K1, K2, K3, K4 and K5. There are 4 types of fault, including single-phase grounding fault, two-phase grounding fault, two-phase short-circuit fault and three-phase short-circuit fault. The first three faults take A-phase grounding, both B and C-phase grounding and both B and C-phase short-circuit as examples, and the above 4 faults are respectively denoted as AG, BCG, BC and ABC.

Table 1 lists the calculated results of three-phase current waveform correlation coefficients on both sides of transmission line under the 4 types of metal short circuit faults at K1, K2, K3, K4 and K5. It is concluded that, for the fault phase under the internal fault of transmission line, the correlation coefficient r is more than -0.3892 (i.e., the set value); for the sound phase under the internal fault of transmission line and all phases under external faults, the correlation coefficient r is less than the set value -0.9. It can thus be seen that both protection devices M and N can reliably and sensitively select the fault phase under the internal fault of transmission line and trip based on the logic diagram; and they can reliably take no action for the sound phases under external and internal faults.

| FaultType | Fault Position | K1 | K2 | K3 | K4 | K5 |
|---|---|---|---|---|---|---|
| AG | A | -0.9994 | -0.9964 | 0.7951 | 0.7893 | 0.6766 |
| | B | -0.9998 | -0.9967 | -1 | -1 | -0.9999 |
| | C | -0.9812 | -0.9962 | -1 | -1 | -0.9998 |
| BCG | A | -0.9999 | -0.9953 | -0.9998 | -0.9995 | -0.999 |
| | B | -0.9979 | -0.9949 | 0.8958 | 0.9729 | 0.1072 |
| | C | -0.9996 | -0.996 | 0.4582 | -0.125 | 0.6011 |
| BC | A | -0.9988 | -0.9996 | -0.9983 | -0.9991 | -0.9994 |
| | B | -0.9998 | -0.9998 | 0.6719 | 0.4114 | 0.2572 |
| | C | -0.9998 | -0.9996 | 0.3303 | 0.0917 | -0.6356 |
| ABC | A | -0.9981 | -0.9974 | -0.3727 | 0.0698 | -0.3892 |
| | B | -0.9951 | -0.9945 | 0.3518 | -0.1953 | 0.4936 |
| | C | -0.9999 | -0.996 | 0.6343 | 0.6898 | 0.5184 |

Table 1 Three-phase current correlation on both sides under different fault conditions

The above mentioned is only a better implementation method of the Invention whose scope of protection is not confined to that however. The changes and replacements within the disclosed technical specification which are easily thought of by any technicians familiar with the Technical Field should be covered within the scope of protection for the Invention. Therefore, the scope of protection for the Invention shall be subject to that in the claims.

**Claims**

1. A pilot protection method for transmission line of renewable energy power station based on current waveform similarity, comprising:

mounting (11) identical relay protection devices respectively on opposite sides (M, N) of a transmission line connected to the renewable energy power station, with each protection device independently measuring the three-phase current of its own side, and acquiring the three-phase current of the opposite side by means of a communication channel (11);
calculating (12) separately the correlation coefficients of each set of relay protection devices, according to the sampled values of the same phase currents in the same time window at the same time on the own side and the opposite side (12);
and each set of relay protection device judging (13) whether there is a fault inside the internal transmission line of the renewable energy power station based on the comparison between the set value and said correlation coefficient of current of each phase and, and enables protective measures according to the fault type (13).

2. A pilot protection method for transmission line of renewable energy power station based on current waveform similarity according to claim 1, wherein the similarity of two current waveforms after failure is used to build protection principle, and the correlation coefficient is used to measure the similarity of said two current waveforms, and wherein said correlation coefficient is determined by the formula:

$$r_p = \frac{\sum_{k=1}^{n}\left(i_{Mp}(k) - \frac{1}{n}\sum_{j=1}^{n}i_{Mp}(j)\right)\left(i_{Np}(k) - \frac{1}{n}\sum_{j=1}^{n}i_{Np}(j)\right)}{\sqrt{\sum_{i=1}^{n}\left(i_{Mp}(k) - \frac{1}{n}\sum_{j=1}^{n}i_{Mp}(j)\right)^2}\sqrt{\sum_{i=1}^{n}\left(i_{Np}(k) - \frac{1}{n}\sum_{j=1}^{n}i_{Np}(j)\right)^2}}, \quad p = A, B, C$$

in which, $r_p$ refers to the correlation coefficient of $p$-phase current on M and N sides; $n$ is the sampling number within N ms of the time window and satisfies $n = N \times 0.001 \times f_s$, $f_s$ is the sampling frequency of relay protection device; $i_{Mp}(k)$ and $i_{Mp}(j)$ are respectively the kth and jth $p$-phase current sampled values of the M side, $i_{Np}(k)$ and $i_{Np}(j)$ respectively the kth and jth $p$-phase current sampled values of the N side.

3. A pilot protection method for transmission line of renewable energy power station based on current waveform similarity according to claim 1, wherein the time window of 10ms for the pilot protection of transmission line is determined based on the transient adjustment time for renewable energy power supply control system.

4. A pilot protection method for transmission line of renewable energy power station based on current waveform similarity according to claim 1, wherein said set value is -0.9.

5. A pilot protection method for transmission line of renewable energy power station based on current waveform similarity according to claim 1, wherein,

if the correlation coefficient of current of any one of A-phase, B-phase and C-phase is more than the set value, it is judged that there is single-phase fault in the internal transmission line of the renewable energy power station and the fault phase is the one whose correlation coefficient is more than the set value, and the relay protection device sends instructions to trip off the circuit breaker of the fault phase;
if the correlation coefficient of current of any two or three of A-phase, B-phase and C-phase is more than the set value, it is judged that there is two-phase or three-phase fault in the internal transmission line of the renewable energy power station, and the fault phases are those whose correlation coefficient is more than the set value, and the relay protection device sends instructions to trip off the three-phase circuit breaker;
if the correlation coefficient of current of A-phase, B-phase and C-phase are all less than the set value, it is judged that there is no fault in the internal transmission line of the renewable energy power station and the relay protection device will not send the instructions of tripping.

**Patentansprüche**

1. Streckenschutzverfahren für eine Übertragungsleitung eines Elektrizitätswerks für erneuerbare Energie basierend auf einer Stromkurvenähnlichkeit, umfassend:

   Montieren (11) identischer Relaisschutzvorrichtungen jeweils auf gegenüberliegenden Seiten (M, N) einer Übertragungsleitung die mit dem Elektrizitätswerk für erneuerbare Energie verbunden ist, wobei jede Schutzvorrichtung den Dreiphasenstrom ihrer eigenen Seite unabhängig misst und den Dreiphasenstrom der gegenüberliegenden Seite mittels eines Kommunikationskanals (11) erfasst;
   getrenntes Berechnen (12) der Korrelationskoeffizienten jedes Satzes von Relaisschutzvorrichtungen gemäß den Abtastwerten der Ströme der gleichen Phase in dem gleichen Zeitfenster gleichzeitig auf der eigenen Seite und der gegenüberliegenden Seite (12);
   und wobei jeder Satz von Relaisschutzvorrichtungen beurteilt (13), ob ein Fehler im Innern der internen Übertragungsleitung des Elektrizitätswerks für erneuerbare Energie besteht, basierend auf dem Vergleich zwischen dem Sollwert und dem Korrelationskoeffizienten des Stroms jeder Phase, und Schutzmaßnahmen gemäß dem Fehlertyp (13) aktiviert.

2. Streckenschutzverfahren für die Übertragungsleitung des Elektrizitätswerks für erneuerbare Energie basierend auf der Stromkurvenähnlichkeit nach Anspruch 1, wobei die Ähnlichkeit von zwei Stromkurven nach einem Ausfall verwendet wird, um ein Schutzprinzip aufzubauen, und der Korrelationskoeffizient verwendet wird, um die Ähnlichkeit der zwei Stromkurven zu messen, und wobei der Korrelationskoeffizient durch die Formel bestimmt wird:

$$r_p = \frac{\sum_{k=1}^{n}\left(i_{Mp}(k) - \frac{1}{n}\sum_{j=1}^{n}i_{Mp}(j)\right)\left(i_{Np}(k) - \frac{1}{n}\sum_{j=1}^{n}i_{Np}(j)\right)}{\sqrt{\sum_{i=1}^{n}\left(i_{Mp}(k) - \frac{1}{n}\sum_{j=1}^{n}i_{Mp}(j)\right)^2}\sqrt{\sum_{i=1}^{n}\left(i_{Np}(k) - \frac{1}{n}\sum_{j=1}^{n}i_{Np}(j)\right)^2}}, \quad p = A,B,C$$

   wobei sich $r_p$ auf den Korrelationskoeffizienten von $p$-Phasenstrom auf Seite M und N bezieht; $n$ die Abtastanzahl innerhalb von N ms des Zeitfensters ist und $n = N \times 0,001 \times f_s$ erfüllt, $f_s$ die Abtastfrequenz der Relaisschutzvorrichtung ist; $i_{Mp}(k)$ und $i_{Mp}(j)$ jeweils der k-te und der j-te $p$-Phasenstromabtastwert der Seite M, $i_{Np}(k)$ und $i_{Np}(j)$ jeweils der k-te und der j-te $p$-Phasenstromabtastwerte der Seite N sind.

3. Streckenschutzverfahren für die Übertragungsleitung des Elektrizitätswerks für erneuerbare Energie basierend auf der Stromkurvenähnlichkeit nach Anspruch 1, wobei das Zeitfenster von 10 ms für den Streckenschutz der Übertragungsleitung basierend auf der transienten Anpassungszeit für ein Steuersystem für eine Elektrizitätsversorgung mit erneuerbarer Energie bestimmt wird.

4. Streckenschutzverfahren für die Übertragungsleitung des Elektrizitätswerks für erneuerbare Energie basierend auf der Stromkurvenähnlichkeit nach Anspruch 1, wobei der Sollwert -0,9 ist.

5. Streckenschutzverfahren für die Übertragungsleitung des Elektrizitätswerks für erneuerbare Energie basierend auf der Stromkurvenähnlichkeit nach Anspruch 1, wobei,

   wenn der Korrelationskoeffizient des Stroms von einer beliebigen einer A-Phase, einer B-Phase und einer C-Phase mehr als der Sollwert ist, beurteilt wird, dass ein Einphasenfehler in der internen Übertragungsleitung des Elektrizitätswerks für erneuerbare Energie vorliegt und die Fehlerphase diejenige ist, dessen Korrelationskoeffizient mehr als der Sollwert ist, und die Relaisschutzvorrichtung Anweisungen sendet, um den Trennschalter der Fehlerphase auszulösen;
   wenn der Korrelationskoeffizient des Stroms von beliebigen zwei oder drei der A-Phase, der B-Phase und der C-Phase mehr als der Sollwert ist, beurteilt wird, dass ein Zweiphasen- oder Dreiphasenfehler in der internen Übertragungsleitung des Elektrizitätswerks für erneuerbare Energie vorliegt, und die Fehlerphasen diejenigen sind, deren Korrelationskoeffizient mehr als der Sollwert ist, und die Relaisschutzvorrichtung Anweisungen sendet, um den Dreiphasentrennschalter auszulösen;
   wenn der Korrelationskoeffizient des Stroms der A-Phase, der B-Phase und der C-Phase alle kleiner als der Sollwert sind, beurteilt wird, dass kein Fehler in der internen Übertragungsleitung des Elektrizitätswerks für erneuerbare Energie vorliegt und die Relaisschutzvorrichtung die Anweisungen des Auslösens nicht sendet.

**Revendications**

1. Procédé de protection de pilote pour une ligne de transmission d'une station d'énergie renouvelable sur la base d'une similarité de forme d'onde de courant, comprenant :

le montage (11) de dispositifs de protection de relais identiques respectivement sur des côtés opposés (M, N) d'une ligne de transmission connectée à la station d'énergie renouvelable, chaque dispositif de protection mesurant indépendamment le courant triphasé de son propre côté, et recevant le courant triphasé du côté opposé au moyen d'un canal de communication (11) ;

le calcul (12) séparé des coefficients de corrélation de chaque ensemble de dispositifs de protection de relais, en fonction des valeurs échantillonnées des courants de même phase dans la même fenêtre temporelle au même moment sur le côté propre et le côté opposé (12) ;

et chaque ensemble de dispositifs de protection de relais, évaluant (13) s'il y a un défaut à l'intérieur de la ligne de transmission interne de la station d'énergie renouvelable sur la base de la comparaison entre la valeur de consigne et ledit coefficient de corrélation de courant de chaque phase, et active des mesures de protection en fonction du type de défaut (13).

2. Procédé de protection de pilote pour une ligne de transmission de station d'énergie renouvelable sur la base d'une similarité de forme d'onde de courant selon la revendication 1, dans lequel la similarité de deux formes d'onde de courant après une défaillance est utilisée pour établir un principe de protection, et le coefficient de corrélation est utilisé pour mesurer la similarité desdites deux formes d'onde de courant, et dans lequel ledit coefficient de corrélation est déterminé par la formule :

$$r_p = \frac{\sum_{k=1}^{n}\left(i_{Mp}(k) - \frac{1}{n}\sum_{j=1}^{n}i_{Mp}(j)\right)\left(i_{Np}(k) - \frac{1}{n}\sum_{j=1}^{n}i_{Np}(j)\right)}{\sqrt{\sum_{i=1}^{n}\left(i_{Mp}(k) - \frac{1}{n}\sum_{j=1}^{n}i_{Mp}(j)\right)^2}\sqrt{\sum_{i=1}^{n}\left(i_{Np}(k) - \frac{1}{n}\sum_{j=1}^{n}i_{Np}(j)\right)^2}}, \quad p = A, B, C$$

dans laquelle, $r_p$ se réfère au coefficient de corrélation d'un courant de phase $p$ sur M et N côtés ; $n$ est le numéro d'échantillonnage dans N ms de la fenêtre temporelle et satisfait $n = N \times 0,001 \times f_s$, $f_s$ est la fréquence d'échantillonnage du dispositif de protection de relais ; $i_{Mp}$ (k) et $i_{Mp}$ (j) sont respectivement les k$^{ième}$ et j$^{ième}$ valeurs échantillonnées de courant de phase $p$ du côté M, $i_{Np}$ (k) et $i_{Np}$ (j) sont respectivement les k$^{ième}$ et j$^{ième}$ valeurs échantillonnées de courant de phase $p$ du côté N.

3. Procédé de protection de pilote pour une ligne de transmission de station d'énergie renouvelable sur la base d'une similarité de forme d'onde de courant selon la revendication 1, dans lequel la fenêtre temporelle de 10 ms pour la protection de pilote de la ligne de transmission est déterminée sur la base du temps de réglage transitoire pour le système de commande d'alimentation en énergie renouvelable.

4. Procédé de protection de pilote pour une ligne de transmission de station d'énergie renouvelable sur la base d'une similarité de forme d'onde de courant selon la revendication 1, dans lequel ladite valeur de consigne est -0,9.

5. Procédé de protection de pilote pour une ligne de transmission d'une station d'énergie renouvelable sur la base d'une similarité de forme d'onde de courant selon la revendication 1, dans laquelle,

si le coefficient de corrélation de courant de l'une quelconque parmi une phase A, une phase B et une phase C est supérieur à la valeur de consigne, il est évalué qu'il y a un défaut monophasé dans la ligne de transmission interne de la station d'énergie renouvelable et que la phase défectueuse est celle dont le coefficient de corrélation est supérieur à la valeur de consigne, et le dispositif de protection de relais envoie des instructions pour déclencher le disjoncteur de la phase de défaut ;

si le coefficient de corrélation de courant de deux ou trois phases quelconques parmi la phase A, la phase B et la phase C est supérieur à la valeur de consigne, il est évalué qu'il y a un défaut à deux ou trois phases dans la ligne de transmission interne de la station d'énergie renouvelable et que les phases défectueuses sont celles dont le coefficient de corrélation est supérieur à la valeur de consigne, et le dispositif de protection de relais envoie des instructions pour déclencher le disjoncteur triphasé ;

si les coefficients de corrélation de courant des phase A, phase B et phase C sont tous inférieurs à la valeur de consigne, il est évalué qu'il n'y a pas de défaut dans la ligne de transmission interne de la station d'énergie renouvelable, et le dispositif de protection de relais n'envoie pas les instructions de déclenchement.

| Mount identical relay protection devices respectively on sides M and N of a transmission line of the renewable energy power station, with each protection device independently measuring the three-phase current of its own side, and acquiring the three-phase current of the opposite side by means of a communication channel; |

— 11

| Each set of relay protection device calculates correlation coefficients according to the same-phase current sampled values within the same time window at the same time on the own side and the opposite side.. |

— 12

| Each set of relay protection device judges whether there is a fault inside the internal transmission line of the renewable energy power station based on the comparison between the set value and the calculated correlation coefficient of current of each phase and then enables protective measures according to the fault type. |

— 13

**Figure 1**

Renewable energy power Station

External System

M

Transmission Line

N

CT

CT

Communication Channel

Relay Protection Device M

Relay Protection Device N

**Figure 2**

$r_A > r_{set}$

$r_B > r_{set}$

$r_C > r_{set}$

& 跳 A-phase tripping

$r_A > r_{set}$

$r_B > r_{set}$

$r_C > r_{set}$

& 跳 B-phase tripping

$r_A > r_{set}$

$r_B > r_{set}$

$r_C > r_{set}$

& 跳 C-phase tripping

$r_A > r_{set}$

$r_B > r_{set}$

&

$r_B > r_{set}$

$r_C > r_{set}$

&

=1 跳 Three-phase tripping

$r_A > r_{set}$

$r_C > r_{set}$

&

（a）

（b）

**Figure 3**

Renewable Energy Power Station

Power Supply 电

Box Transformer

Collection System

Main Transform

M  K3  K4  K5  N  K2

Transmission Line

External System 外部系统

**Figure 4**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201710017380
- CN 105356428

- CN 105891676